# EUROPÄISCHE PATENTSCHRIFT

(11) **EP 1 826 254 B1**
(45) Veröffentlichungstag und Bekanntmachung des Hinweises auf die Patenterteilung: **11.04.2012**
(21) Anmeldenummer: 07102240.4
(22) Anmeldetag: 13.02.2007
(51) Int. Cl.: C09G 1/02, C09K 3/14

(54) **Poliermittel enthaltend Gluconsäure**
Polishing agent based on gluconic acid
Agent de polissage à base d'acide gluconique

(30) Priorität: 24.02.2006 DE 102006008689
(43) Veröffentlichungstag der Anmeldung: 29.08.2007
(73) Patentinhaber: Akzo Nobel Chemicals International B.V., 3811 MH Amersfoort (NL)
(72) Erfinder: Dr. Hey, Gabriele, 51519, Odenthal (DE); Dr. Aghina, Alessandro, 20122 Milano (IT)
(74) Vertreter: Schalkwijk, Pieter Cornelis

(56) Entgegenhaltungen:
- DE-A1- 10 304 894
- FR-A1- 2 816 527
- US-A- 4 915 710

## Beschreibung

Die Erfindung betrifft die Verwendung von Gluconaten bei der Herstellung von Halbleiterscheiben, bevorzugt beim Polieren der Halbleiterscheiben während des Herstellprozesses, sowie ein Poliermittel auf Basis eines Abrasivstoffes und/oder Kolloides und einer Mischung aus Disuccinaten oder Methylglycindiessigsäure (MGDA) und Gluconaten.

Verfahren zur Politur von Halbleiterscheiben sind bekannt. Die Halbleiterscheiben werden dabei über einen mit Poliertuch bedeckten Polierteller bewegt, wobei ein Poliermittel zugeführt wird. Das Poliermittel enthält Abrasivstoffe oder Kollide und ist - je nach Anwendungsbereich - sauer, neutral oder alkalisch. Die Halbleiterscheibe, beispielsweise eine Halbleiterscheibe aus Silicium, ist unbedeckt oder mit natürlichem Oxid von 1 bis 1,5 nm Dicke bedeckt oder im Falle der Fertigung elektronischer Bauelemente zumindest teilweise mit künstlich aufgebrachten Schichten und/oder Strukturen bedeckt. Als chemisch mechanische Politur kommen bei der Durchführung vielfach alkalische Suspensionen auf Kieselsäurenbasis beispielsweise gemäß der DE 198 17 087 A1 und der DE 100 63 488 A1 zum Einsatz, die mit einer Fülle weiterer Abrasivstoffe versetzt sein können.

Das Niveau an Metallkontamination spielt in den meisten Fällen eine bedeutende Rolle, da bei Überschreiten kritischer Grenzen eine Vielzahl negativer Effekte im Bauelemente-Herstellungssprozess hervorgerufen wird, was zwangsläufig mit Ausbeuteverlusten verbunden ist. Eine Sonderstellung nimmt Kupfer ein, das bereits bei Raumtemperatur in eine nicht durch das natürliche Oxid geschützte Siliciumoberfläche eindringt, beispielsweise während der Politur. Bei der Politur von Halbleiterscheiben im Rahmen der Bauelementefertigung wird heute teilweise bewusst Kupfer beispielsweise zur Erzeugung elektrischer Leiterbahnen eingesetzt.

Daher wurden Poliermittel entwickelt, die unerwünschte Kupferspuren bei der Politur unbedeckter Halbleiterscheiben oder durch die Politur aus Bauelementeschichten oder -strukturen freigesetztes Kupfer binden und somit dem Gleichgewicht entziehen. Dies gelingt gemäß der WO 01/06553 A1 durch die Bildung schwer löslicher Kupferverbindungen. Eine andere Strategie ist der Einsatz von Chelatbildnern (englisch "chelating agents"), die beispielsweise in US 5 366 542, US 2002/0124474 A1, JP 2001 077 063 A, JP 2001 176 826 A und EP 1 229 094 A1 beansprucht sind. Derartige Chelatbildner sind multifunktionale organische Moleküle, die mit mindestens zwei über ein freies Elektronenpaar verfügende Koordinationsstellen Käfigverbindungen (Chelate) mit Metallionen, beispielsweise positiv geladenem Kupfer (Cu²⁺) bilden und damit ebenfalls zur Kupferbindung beitragen. Effektive Chelatbildner sind Essigsäurederivate wie Iminodiacetat (IDA), Ethylendiamintetracetat (EDTA) und Diethylentriaminpentaacetat (DTPA), die in der Regel in Form ihrer technisch leicht zugänglichen Natriumsalze eingesetzt werden, beispielsweise Na₂IDA, Na₄EDTA und Na₅DTPA.

Nachteil von Poliermitteln mit Chelatbildnern mit Acetatgruppen ist, dass sie in der biologischen Abwasseraufbereitung nur schwer abbaubar sind und entweder zu ökologischen Schäden führen oder in kostenintensiven zusätzlichen Abwasserbehandlungsverfahren wie Oxidation mit Ozon oder Verbrennung eleminiert werden müssen. In DE 10 304 894 B4 entwickelte man daher ein Poliermittel auf Basis von Disuccinaten. In der Anwendung zeigte sich jedoch, dass das Komplexiervermögen der Disuccinate begrenzt ist und es insbesondere bei Anwesenheit von Eisen-Ionen zu unerwünschten Ausfällungen von Eisenhydroxid kommen kann.

Aufgabe der Erfindung ist es, ein Poliermittel bereitzustellen, das für die Politur von Halbleiterscheiben geeignet ist, einen Chelatbildner mit hohen Komplexierungsfähigkeit für Kuperionen beinhaltet und gleichzeitig nicht zu Problemen in der biologischen Abwasseraufbereitung führt sowie unerwünschte Ausfällungen, insbesondere die von Eisenhydroxiden, verhindert.

Im Rahmen der Arbeiten zur vorliegenden Erfindung wurde gefunden, dass sich Gluconate, bevorzugt Alkalisalze oder Erdalkalisalze der Gluconsäure, besonders bevorzugt die Alkalisalze der Gluconsäure bei der Herstellung vom Halbleiterschieben, besonders bevorzugt beim Polieren der Halbleiterscheiben während des Herstellprozesses, einsetzen lassen.

Gegenstand der Erfindung ist aber auch ein Poliermittel, das als Bestandteile
a) Wasser,
b) Abrasivstoff und/oder Kolloid,
c) Methylglycerindiessigsäure (MGDA) oder ein Disuccinat der Formel 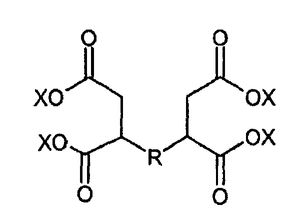 worin
   - R: für -(NH-CH₂-CH₂-)ₙNH- steht,
   - X: für Wasserstoff und/oder für ein Alkalimetall steht und
   - n: für eine ganze Zahl von 0 bis 2 steht und
d) ein Alkalisalz oder Erdalkalisalz der Gluconsäure
enthält.

Gegenstand der Erfindung ist außerdem ein Verfahren zur Politur einer Halbleiterscheibe mit einer Vorderseite und einer Rückseite und einer Kante, das dadurch gekennzeichnet ist, dass ein derartiges Poliermittel verwendet wird.

Überraschenderweise zeigen die erfindungsgemäßen Poliermittel enthaltend die Kombination von MGDA oder Disuccinaten und Gluconaten einerseits die aus der DE 10 304 894 B1 bekannten Vorteile, zusätzlich jedoch hervorragende Komplexiereigenschaften im Hinblick auf zusätzliche störende Kationen wie Eisen, Kupfer und Nickel.

Nachfolgend sind die Bestandteile des erfindungsgemäßen Poliermittels und dessen Verwendung in der Politur von Halbleiterscheiben näher beschrieben. Als Bestandteil (a) wird aus vielfachen Gründen prinzipieller, technologischer und ökologischer Natur sowie aus Kostenfaktor-Gründen Wasser als Fluid beziehungsweise Trägermedium für die Inhaltsstoffe des Poliermittels gewählt. Bevorzugt ist durch Destillation, Entsalzung, Umkehrosmose, Filtration und/oder vergleichbare Verfahren gereinigtes Wasser. Besonders bevorzugt ist Reinstwasser mit einer Leitfähigkeit von 18 (MΩ·cm)⁻¹. Wasser liegt bevorzugt in einem Anteil von 45 bis 99,9 Masse-% und besonders bevorzugt in einem Anteil von 84 bis 99,8 Masse-% im erfindungsgemäßen Poliermittel vor. Im Bedarfsfall können aber auch Mischungen von Wasser mit organischen oder anorganischen Lösungsmitteln eingesetzt werden.

Als Abrasivstoff und/oder Kolloid (Bestandteil (b)) eignet sich eine Vielzahl wässeriger Suspensionen von Abrasivstoffen oder wässeriger Sole beziehungsweise Kolloide mit definierter Korngrößenverteilung, die je nach Anwendungszweck im Nanometer- bis Mikrometerbereich liegen kann. Als Feststoffe lassen sich dabei beispielsweise SiO₂, TiO₂, ZrO₂, CeO₂, SnO₂, Al₂O₃, Si₃N₄ und/oder SiC einsetzen. Im Rahmen der Politur von Halbleiterscheiben insbesondere aus Silcium ist als Bestandteil (b) Kieselsäure in einem Anteil von 0,05 bis 50 Masse-%, bezogen auf SiO₂, bevorzugt; besonders bevorzugt ist dabei ein Anteil von 0,1 bis 10 Masse-%, bezogen auf SiO₂. Die Herstellung entsprechender Kieselsäuren kann nach dem Stand der Technik durch Fällung und Reinigung beispielsweise von Wasserglas (Natriumsilikat), durch Hydrolyse von Kieselsäureestern oder durch Verbrennung von SiCl₄ erfolgen. Im Falle des Einsatzes von Kieselsäure als Bestandteil (b) ist eine alkalische Stabilisierung bevorzugt.

Als Bestandteil (c) werden MGDA oder Disuccinate eingesetzt. Disuccinate sind Verbindungen mit zwei Bernsteinsäureeinheiten (englisch "succinic acid"), mit der Formel 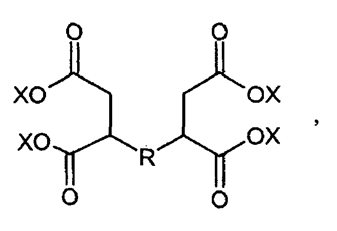 die mit ihren Carbonsäuregruppen bereits vier potenzielle Koordinationsstellen zur Bildung von Komplexen mit mehrwertigen Metallen besitzen. Enthält die Verbindungsgruppe R zusätzlich mindestens ein Stickstoffatom mit einem freien Elektronenpaar, liegt ein Chelatbildner vor, der im Unterschied zu den Chelatbildnern in Poliermitteln nach dem Stand der Technik mit ihren stark Elektronen ziehenden Acetatgruppen am Stickstoffatom biologisch abbaubar ist und dennoch gute Komplexierungseigenschaften für mehrwertige Übergangsmetallionen besitzt.

Erfindungsgemäß bewährt haben sich neben MGDA Disuccinate mit R = -(NH-CH₂-CH₂-)ₙNH-, wobei n eine ganze Zahl von 0 bis 2 darstellt und X für Wasserstoff oder Alkalimetall steht:

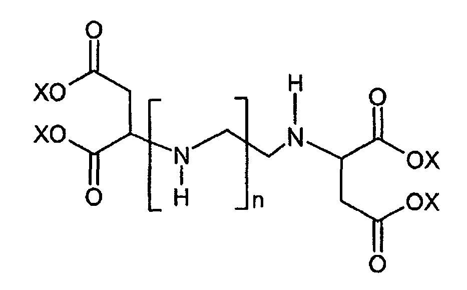

Bevorzugte Verbindungen dieser Gruppe (c) sind neben MGDA die drei Vertreter: Iminodibernsteinsäure (englisch "iminodisuccinic acid", Abkürzung IDS; n = 0), und ihre Salze, beispielsweise Tetranatriumiminodisuccinat (Na₄IDS) mit der Formel

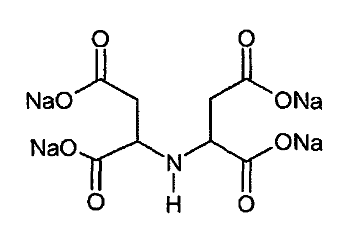

Diese Verbindungen und ihre Verwendung in der Papierherstellung sind beispielsweise in der DE 197 13 911 A1 beschrieben.

Ferner bevorzugte Verbindungen der Gruppe (c) ist Ethylendiamindibernsteinsäure (englisch "ethylendiamin disuccinic acid", Abkürzung EDDS; n = 1), und ihre Salze, beispielsweise Tetranatriumethylendiamindisuccinat (Na₄EDDS) mit der Formel

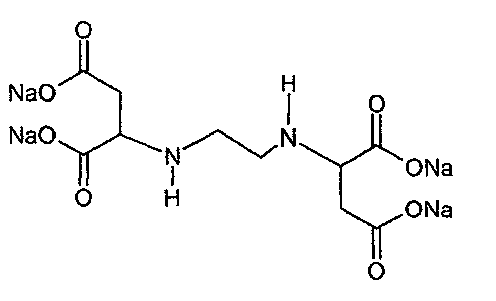

Diese Verbindungen und ihre Verwendung in Fotografie, Gasbehandlung und Kupferabscheidung sind beispielsweise aus der US 5 859 273 bekannt. Ebenfalls zur Ausübung der Erfindung geeignet als Bestandteil (c) ist Diethylentriamindisuccinat (englisch "diethylentriamin disuccinic acid", Abkürzung DTDS; n = 2), und ihre Salze, beispielsweise Tetranatriumdiethylentriamindissuccinat (Na₄DTDS).

Erfindungsgemäß bevorzugt sind also Poliermittel, die als Bestandteil (c) Iminodibernsteinsäure (n = 0) und/oder Ethylendiamindibernsteinsäure (n = 1) und/oder Diethylentriamindisuccinat und/oder ein oder mehrere Salze dieser Verbindungen oder Methylglycindiessigsäure enthalten.

MGDA und die genannten Verbindungen IDS, EDDS und DTDS werden, letztere bevorzugt als Säure oder Alkalisalz, in einem Anteil von 0,005 bis 5 Masse-% zugegeben. Besonders bevorzugt ist die Zugabe des MGDA oder eines Natrium- und/oder Kaliumsalzes des IDS, EDDS oder DTDS in einem Anteil von 0,01 bis 1 Masse-%. Bei Vorliegen der genannten Anteile werden im erfindungsgemäßen Poliermittel vorliegende Schwermetallionen wie Cu²⁺, Ni²⁺ und Fe³⁺ effektiv gebunden. Die resultierenden Chelate bleiben in Lösung, jedoch die störenden Metallionen, beispielsweise Cu²⁺ in der Politur von Halbleiterscheiben, dadurch chemisch blockiert und unschädlich gemacht. Der signifikante Unterschied zu den in Poliermitteln nach dem Stand der Technik enthaltenen Chelatbildnern mit Acetatresten liegt darin, dass MGDA und die genannten Dibemsteinsäuren sowie ihre Salze und damit gebildete Chelate mit Metallionen in den üblichen biologischen Kläranlagen problemlos abgebaut werden, was beispielsweise bei IDA, EDTA und DTPA nicht der Fall ist. Das im Falle der letztgenannten Chelatbildner vorhandene Risiko, dass derartige Stoffe unzersetzt in die Umwelt gelangen und beispielsweise giftige Schwermetalle aus Klärschlämmen oder Sedimenten herauslösen, ist bei MGDA, IDS, EDDS und DTDS nicht gegeben.

Als Komponente (d) werden Alkalisalze oder Erdalkalisalze der Gluconsäure eingesetzt. Für den Einsatz als Poliermittel sind alle Formen der Salze der Gluconsäure einsetzbar. Am preiswertesten ist D (+) Gluconsäure [CAS 526-95-4] bzw. deren Alkali oder Erdalkalisalze. Erfindungsgemäß bevorzugt sind die Alkalisalze der Gluconsäure, insbesondere die Natrium- oder Kaliumsalze der Gluconsäure.

Die Komponente (d) ist im erfindungsgemäßen Poliermittel zu 0,005 bis 5 Masse-%, bevorzugt zu 0,01 bis 0,5 Masse-% enthalten.

Der bevorzugte pH-Wert die Bestandteile (a) bis (c) oder die Bestandteile (a) bis (d) enthaltender Poliermittel liegt bei pH 8 bis pH 13, besonders bevorzugt bei pH 9 bis pH 12.

Ein Poliermittel aus den Bestandteilen (a), (b), (c) und (d) kann in verschiedenen Fällen bereits in der Lage sein, seinen Bestimmungszweck zu erfüllen. Dies gilt beispielsweise für solche Fälle, in denen eine Politur mit hoher mechanischer Komponente etwa mit Al₂O₃ als Abrasivstoff durchgeführt wird. Dies gilt ebenso, falls ein alkalisches System benötigt wird und der eingesetzte Abrasivstoff oder das Kolloid, beispielsweise Kieselsäure, bereits ausreichend alkalisch stabilisiert ist und der in diesem Falle bevorzugte pH-Wert von 8 bis 13 erreicht wird. Von Vorteil dabei ist, dass etwa handelsübliche Kieselsäurekolloide insbesondere nach der Entfernung beispielsweise von Alkalimetallionen durch Ionenaustausch bereits eine in einigen Fällen ausreichende Alkalinität und Pufferwirkung besitzen. Jedoch kann es auch Fälle insbesondere bei Durchführung einer chemisch-mechanischen Politur ("chemical mechanical pilishing", CMP) geben, in denen die zusätzliche Zuführung alkalischer Verbindungen zur Einstellung des gewünschten pH-Wertes und/oder Bildung eines Puffersystems mit erhöhter Pufferkapazität und somit geringer pH-Wert-Schwankung während der Politur von Vorteil ist. In ihrer grundsätzlichen Natur unterscheiden sich die erfindungsgemäßen Poliermittel ohne und mit Zugabe weiterer Bestandteile jedoch nicht.

Geeignet als gegebenenfalls zusätzliche Bestandteile (e) sind basische Salze oder Hydroxide von Alkalimetallionen oder Ammoniumionen in einem Anteil von bevorzugt 0,01 bis 10 Masse-% und besonders bevorzugt 0,05 bis 5 Masse-%. Alkalimetalle sind Lithium, Natrium, Rubidium und Cäsium; Natrium- (Na⁺) und Kaliumionen (K⁺) sind bevorzugt. Ammoniumionen sind beispielsweise Ammonium (NH₄⁺) und Tetramethylammonium (N(CH₃)₄⁺, Abkürzung (TMAH). Alkalische Salze sind beispielsweise Carbonate (CO₃²⁻) und Hydrogencarbonate (HCO₃⁻) der genannten Kationen. Alkalische Na- und/oder K-Salze sind bei Ausführung der Erfindung bevorzugt; Na₂CO₃ und K₂CO₃ sind besonders bevorzugt.

Das erfindungsgemäße Poliermittel kann darüber hinaus noch über weitere Bestandteile verfügen, die den jeweiligen Anwendungszweck aus der vielfältigen Auswahl der Einsatzmöglichkeiten unterstützen. Diese weiteren Bestandteile sollten einen Anteil von bevorzugt 5 Masse-% und besonders bevorzugt 1 Masse-% nicht überschreiten, um die Natur des erfindungsgemäßen Poliermittels nicht zu verändern. Derartige weitere Bestandteile können beispielsweise Oxidationsmittel, wie Wasserstoffperoxid, Polierbeschleuniger und Antikorrosiva, wie Amine und Carbonsäuren, wie Butanol und Polyvinylalkohol, und weitere organische Verbindungen, wie Zelluloseverbindungen und Aminosäuren, und anorganische Verbindungen, wie Salze, Oxide und Hydroxide, sein.

Für die Bereitstellung des erfindungsgemäßen Poliermittels sind verschiedene Variationen denkbar. So können alle Bestandteile in einem Behälter beispielsweise durch Rühren oder Umpumpen gemischt und durch Pumpen oder Gravition zur Polieranlage gefördert werden. Eine Vorverdünnung konzentrierter Lösungen der Bestandteile kann sinnvoll sein. Es ist jedoch auch möglich und kann in der Praxis insbesondere bei Zugabe des alkalischen Bestandteils (e) Vorteile bringen, zwei Vormischungen, beispielsweise Wasser mit Abrasivstoff, Kolloid und Na₄IDS, MGDA oder Na₄DTDS und Gluconat (Vormischung 1) und Wasser mit alkalischem Bestandteil (e) (Vormischung 2) herzustellen und diese erst am Ort der Politur zu vereinigen. Bei allen ausführbaren Arbeitsweisen ist zu beachten, dass der für Suspensionen des eingesetzten Bestandteils (b) geeignete pH-Wert-Bereich auch nicht kurzfristig in Richtung zu sauer oder zu alkalisch verlassen wird, um eine Fällung oder Gelbildung zu vermeiden, welche die Eigenschaften des Poliermittels negativ beeinträchtigen würden.

Das erfindungsgemäße Poliermittel ist auch zur Wiederverwendung ("recycling") geeignet. Dabei wird in der Regel jeweils ein Teil des verbrauchten Poliermittels durch frisches Poliermittel ersetzt oder durch gezielte Zufuhr der verbrauchten Bestandteile aufgefrischt. Nach einer gewissen Anzahl von Polierfahrten beziehungsweise nach einer bestimmten Einsatzdauer ist es ratsam, den Poliermittelansatz komplett durch einen frischen Ansatz zu ersetzen. Auf diese Weise wird einer schleichenden Veränderung der Poliermitteleigenschaften begegnet und eine zu starke Akkumulation von Schwermetallionen, vor allem Kupfer und Nickel, die allerdings in Form der Dibemsteinsäurechelate oder Chelate mit MGDA vorliegen, begegnet.

Das erfindungsgemäße Poliermittel eignet sich für eine Fülle von Anwendungen, wobei im Hinblick auf Kontamination mit metallischen Verunreinigungen, vor allem Kupfer und Nickel, Halbleiterscheiben das bevorzugte Objekt der Politur sind. Der als Bestandteil (b) vorliegende Chelatbildner (MGDA oder IDS, EDDS und/oder DTDS; als freie Säure oder Salz) schützt die Halbleiterscheiben während der Politur vor einem Eintrag dieser Metalle durch Bildung von Chelaten, die zwar in Lösung bleiben, Ionen wie Cu²⁺ und Ni²⁺ jedoch chemisch deaktivieren und am Einbau in das Gitter der Halbleiterscheibe hindern. Vom Prinzip her lassen sich zwei Arten von Polierprozessen unterscheiden: (1) Politur von unbeschichteten oder nur mit dem natürlichen Oxid ("native oxide") beschichteten Halbleiterscheiben beispielsweise aus Silicium, bei denen etwa Cu²⁺ und Ni²⁺ als unvermeidbare Kontaminationen vorliegen und blockiert werden sollen, und (2) Politur von Halbleiterscheiben während der Bauelementefertigung, die mit künstlich aufgebrachten Schichten und/oder Strukturen bedeckt sind, die gezielt zugesetztes Kupfer enthalten können, welches durch den Chelatbildner unmittelbar bei der Freisetzung blockiert wird und nicht in andere Bestandteile des Bauelementes oder die Halbleiterscheibe selbst eindringt und Schaden beispielsweise durch elektrische Kriechströme oder sogar Kurzschlüsse verursacht.

Im Rahmen der Politur (1) von unbeschichteten oder nur mit dem natürlichen Oxid beschichteten Halbleiterscheiben beispielsweise aus Silicium mit einer Kante und einer Vorderseite und einer Rückseite lassen sich verschiedene Anwendungen des erfindungsgemäßen Poliermittels unterscheiden. So kann die Kante der Halbleiterscheibe poliert werden, um ein Anhaften von Partikeln bei der Bauelementeherstellung zu vermeiden. Liegt ein Notch als Orientierungsmerkmal für die Kristallachsen vor, kann dieser ebenfalls poliert werden. Für diese Anwendungen sind am Markt Kantenpolierautomaten geeigneter Größe erhältlich.

Die Ausübung des erfindungsgemäßen Polierprozesses zur Politur mindestens einer Vorderseite der Halbleiterscheibe gelingt entweder als einseitig oder als beidseitig angreifende Politur ebenfalls auf Anlagen nach dem Stand der Technik. Bei der einseitig angreifenden Politur sind eine oder mehrere meist geätzte Halbleiterscheiben mit ihrer Rückseite gehalten durch Wachs, Vakuum oder Adhäsion an einer Trägereinheit befestigt und werden mit der Vorderseite in der Regel rotierend über einen meist ebenfalls rotierenden, mit Poliertuch beklebten Polierteller unter kontinuierlicher Zuführung eines die Bedingungen der Erfindung erfüllenden Poliermittels bewegt. Bei der beidseitig angreifenden Politur werden eine oder mehrere Siliciumscheiben zwischen zwei in der Regel gegenläufig rotierenden, mit Poliertuch beklebten Poliertellern ebenfalls unter kontinuierlicher Zuführung des besagten Poliermittels bewegt, wobei sie sinnvoller Weise von einer oder mehreren Läuferscheiben auf einer vorbestimmten Bahn relativ zu den Poliertellern bewegt werden, was eine gleichzeitige Politur der Vorderseite und der Rückseite der Siliciumscheiben zur Folge hat.

Ein im Rahmen der Erfindung besonders bevorzugtes Poliermittel für die Politur von unbeschichteten oder mit natürlichem Oxid beschichteten Halbleiterscheiben aus Silicium besitzt einen pH-Wert von 9 bis 12 und enthält Wasser in einem Anteil von 84 bis 99,8 Masse-%, gefällte Kieselsäure in einem Anteil von 0,1 bis 10 Masse-%, gerechnet als SiO₂, Natrium- oder Kaliumsalz der Iminodibernsteinsäure und/oder der Ethylendiamindibernsteinsäure oder MGDA in einem Anteil von 0,01 bis 1 Masse-%, Natrium- und/oder Kaliumcarbonat in einem Anteil von 0,05 bis 5 Masse-% sowie Natrium- oder Kaliumgluconat in einem Anteil von 0,001 bis 0,5 Masse-%.

Die Politur (2) von Halbleiterscheiben während der Bauelementefertigung, die mit künstlich aufgebrachten Schichten und/oder Strukturen bedeckt sind, spielt während der Fertigung von Bauelementen moderner Generationen inzwischen eine große Rolle. Hierbei kommen in der Regel Einseiten-Polierverfahren und -anlagen zum Einsatz, die den unter (1) beschriebenen vergleichbar sind. Das Verfahren wird in diesem Falle als chemisch-mechanische Planarisierung (ebenfalls CMP abgekürzt) bezeichnet. Insbesondere zur Politur von Schichten aus Wolfram und Kupfer ist das erfindungsgemäße Poliermittel hervorragend geeignet. Im Vergleich zur Politur von unbelegten Oberflächen sind in diesem Fall Abrasivstoffe und/oder Kolloide mit gröberer Körnung und härtere Poliertücher bevorzugt.

Die analytische Bestimmung des Kupfergehaltes im Siliciumgitter kann durch Methoden erfolgen, welche eine relativ hohe Wiederfindungsrate, beispielsweise eine Wiederfindungsrate von über 90 %, ausweisen. Dazu kann die zu analysierende Siliciumscheibe komplett in einem hochreinen Gemisch aus konzentrierter Salpetersäure und konzentrierter Flusssäure aufgelöst und der Kupferanteil nach Abrauchen und Aufnehmen in verdünnter Säure spektroskopisch ermittelt werden. Diese Methode ist aufwändig und mit einem relativ hohen Messfehler behaftet. Bevorzugt ist eine Methode, bei der getterfähige Schichten, die Kupfer nahezu quantitativ an die Oberfläche ziehen, beispielsweise bestehend aus Polysilicium, bei erhöhten Temperaturen auf die Oberfläche der Siliciumscheibe aufgedampft und anschließend chemisch abgelöst und analysiert werden.

Der Zusatz von MGDA oder IDS, EDDS, DTDS oder deren Salze als Bestandteil (c) in Verbindung mit Gluconaten als Bestanteil (d) im erfindungsgemäßen Poliermittel verknüpft in hervorragender Weise eine effektive Chelatisierung und damit Blockierung beispielsweise von Kupferionen mit dem ökologischen Aspekt der biologischen Abbaubarkeit verbunden mit dem Vorteil deutlich verringerter Entsorgungskosten für das verbrauchte Poliermittel sowie einer insbesondere im Alkalischen auftretenden Ausfällung von Hydroxiden, insbesondere Eisenhydroxiden.

### Beispiele

| | wässriges Poliermittel (pH 11,0) zur Politur von Siliciumscheiben (Anteile in Masse-%) | | | | Polierverfahren | Biol. Abbaubar | Kupfer in Si Scheibe (Masse in ppb) | Fe in Form von Hydroxydausfällungen nach meheren Polierungen |
|---|---|---|---|---|---|---|---|---|
| | (b) | (c) | (d) | (e) | | | | |
| - | - | - | - | - | (vorher) | - | < 0,1 | - |
| V1 | Si02 (3,0) | - | - | K2C03 (2,0) | DSP | ja | 3.5 | ja |
| V2 | SiO2(3,0) | Na4IDS (0,15) | - | K2CO3 (2,0) | DSP | ja | 0.3 | ja |
| V3 | Si02 (3,0) | Na4EDDS (0,15) | - | K2CO3 (2,0) | DSP | ja | 0.4 | ja |
| V4 | SiO2 (3,0) | Na3MGDA (0,15) | - | K2C03 (2,0) | DSP | ja | 0.4 | ja |
| V5 | Si02 (3,0) | Na4EDTA (0,15) | - | K2CO3 (2,0) | DSP | nein | 0.3 | nein |
| V6 | Si02 (3,0) | Na5DTPA(0,15) | - | K2CO3 (2,0) | DSP | nein | 0.4 | nein |
| V7 | Si02 (3,0) | Na4IDS (0,15) | NaGluconat (0,05) | K2CO3 (2,0) | DSP | ja | 0.3 | nein |
| V8 | Si02 (3,0) | Na4EDDS (0,15) | NaGluconat (0,05) | K2CO3 (2,0) | DSP | ja | 0.4 | nein |
| V9 | Si02 (3,0) | Na3MGDA (0,15) | NaGluconat (0,05) | K2CO3 (2,0) | DSP | ja | 0.4 | nein |
| V10 | Si02 (3,0) | Na4IDS (0,15) | - | K2CO3 (2,0) | SSP | ja | 0.2 | ja |
| V11 | Si02 (3,0) | Na4EDTA (0,15) | - | K2C03 (2,0) | SSP | nein | 0.2 | nein |
| V12 | SiO2 (3,0) | Na5DTPA (0,15) | - | K2CO3 (2,0) | SSP | nein | 0.3 | nein |
| V13 | SiO2 (3,0) | Na4IDS (0,15) | NaGluconat (0,05) | K2C03 (2,0) | SSP | ja | 0.2 | nein |
| V14 | Si02 (3,0) | - | - | K2CO3 (2,0) | SSP | ja | 1.5 | nein |

## Patentansprüche

1. Poliermittel, enthaltend als Bestandteile
a) Wasser, 06. 05. 2011
b) Abrasivstoff und/oder Kolloid,
c) Methylglycindiessigsäure oder ein Disuccinat der Formel 49 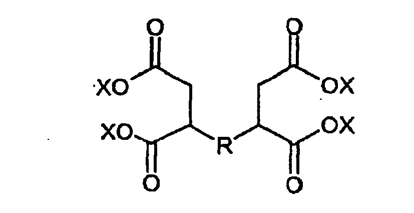 worin
R für -(NH-CH₂-CH₂-)ₙNH- steht,
X für Wasserstoff und/oder für ein Alkalimetall steht,
n eine ganze Zahl von 0 bis 2 ist und
d) ein Alkalisalz-oder Erdalkalisalz der Gluconsäure.

2. Poliermittel nach Anspruch 1, **dadurch gekennzeichnet, dass** als Bestandteil (b) Kieselsäure in einem Anteil von 0,05 bis 50 Masse-%, gerechnet als SiO₂, enthalten ist.

3. Poliermittel nach Anspruch 1 oder Anspruch 2, **dadurch gekennzeichnet, dass** der pH-Wert von 8 bis 13 beträgt.

4. Poliermittel nach einem der Ansprüche 1 bis 3, **dadurch gekennzeichnet, dass** als Alkalisalze der Gluconsäure die Natrium- oder Kaliumsalze eingesetzt werden.

5. Poliermittel nach einem der Ansprüche 1 bis 4, **dadurch gekennzeichnet, dass** als Bestandteil (c) Iminodibernsteinsäure (n = 0) und/oder Ethylendiamindibemsteinsäure (n = 1) und/oder Diethylentriamindisuccinat und/oder ein oder mehrere Salze dieser Verbindungen oder Methylglyclndiessigsäure enthalten ist.

6. Poliermittel nach einem der Ansprüche 1 bis 5, **dadurch gekennzeichnet, dass** Bestandteil (c) in einem Anteil von 0,005 bis 5 Masse-% enthält.

7. Poliermittel nach einem der Ansprüche 1 bis 6, **dadurch gekennzeichnet, dass** als weiterer Bestandteil (e) ein oder mehrere basische Salze und/oder Hydroxide von Alkalimetalilonen und/oder Ammoniumionen in einem Anteil von 0,01 bis 10 Masse-% enthalten sind.

8. Poliermittel nach einem der Ansprüche 1 bis 7 mit einem pH-Wert von 9 bis 12, enthaltend als Bestandteile
(a) Wasser in einem Anteil von 84 bis 99,8 Masse-%,
(b) Kieselsäure in einem Anteil von 0,1 bis 10 Masse-%, gerechent als SiO₂,
(c) Natrium- oder Kaliumsalz der Iminodibernsteinsäure und/oder der Ethylendiamindibemsteinsäure in einem Anteil von 0,01 bis 1 Masse-%, und
(d) Natrium- und/oder Kaliumcarbonat in einem Anteil von 0,05 bis 5 Masse%,
(e) Kalium- oder Natriumgluconat zu einem Anteil von 0,01-0,5 Masse-%.

9. Verfahren zur Politur einer Halbleiterscheibe mit einer Vorderseite und einer Rückseite und einer Kante, **dadurch gekennzeichnet, dass** ein Poliermittel gemäß einem der Ansprüche 1 bis 8 verwendet wird.

10. Verfahren nach Anspruch 9, **dadurch gekennzeichnet, dass** die Halbleiterscheibe im Wesentlichen aus Silicium besteht.

11. Verfahren nach Anspruch 9 oder 10, **dadurch gekennzeichnet, dass** zumindest ein Teil der Vorderseite der Halbleiterscheibe mit künstlich aufgebrachten Schichten und/oder Strukturen bedeckt ist.

12. Verfahren nach Anspruch 11, **dadurch gekennzeichnet, dass** in den Schichten und/oder Strukturen Kupfer als elektrischer Leiter enthalten ist.

13. Verfahren nach Anspruch 9 oder 10, **dadurch gekennzeichnet, dass** die Vorderseite der Siliciumscheibe unbedeckt oder mit natürlichem Oxid bedeckt ist und unter Zuführung eines Poliermittels gemäß einem der Ansprüche 1 bis 9 poliert wird.

14. Verfahren nach Anspruch 9 oder 10, **dadurch gekennzeichnet, dass** die Vorderseite und die Rückseite der Siliciumscheibe unbedeckt oder mit natürlichem Oxid bedeckt ist und unter Zuführung eines Poliermittels gemäß einem der Ansprüche 1 bis 9 poliert wird.

15. Verfahren nach Anspruch 9 oder 10, **dadurch gekennzeichnet, dass** die Kante der Siliciumscheibe unter Zuführung eines Poliermittels gemäß einem der Ansprüche 1 bis 9 poliert wird.

16. Verfahren nach einem der Ansprüche 9 bis 15, **dadurch gekennzeichnet, dass** zumindest ein Teil des eingesetzten Poliermittels wiederverwendet wird.

17. Verwendung einer Mischung aus
a) Wasser,
b) Abrasivstoff und/oder Kolloid,
c) Methylglycindiessigsäure oder ein Disuccinat der Formel 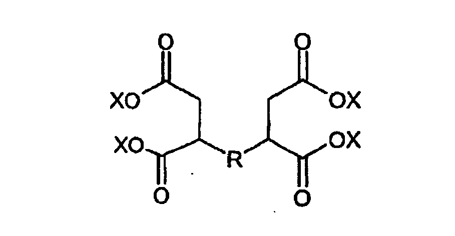 worin
X und R die in Anspruch 1 genannten Bedeutungen haben und
(d) Alkali-oder Erdalkalisalzen der Gluconsäure als Poliermittel, bevorzugt als Poliermittel für Halbleiterscheiben.

## Claims

1. Polishing agent, containing as constituents
a) water,
b) abrasive substance and/or colloid,
c) methylglycine diacetic acid or a disuccinate of the formula 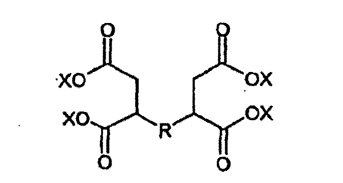 wherein
R stands for -(NH-CH₂-CH₂-)ₙNH-,
X stands for hydrogen and/or for an alkali metal,
n is an integer from 0 to 2, and
d) an alkali salt or alkaline-earth salt of gluconic acid.

2. Polishing agent according to claim 1, **characterised in that** as constituent (b) silicic acid in a share of 0.05 to 50 mass%, calculated as SiO₂, is included.

3. Polishing agent according to claim 1 or claim 2, **characterised in that** the pH-value is 8 to 13.

4. Polishing agent according to any one of claims 1 to 3, **characterised in that** as alkali salts of gluconic acid sodium or potassium salts are used.

5. Polishing agent according to any one of claims 1 to 4, **characterised in that** as constituent (c) iminodisuccinic acid (n = 0) and/or ethylenediamine disuccinic acid (n = 1) and/or diethylenetriamine disuccinate and/or one or several salts of these compounds or methylglycine diacetic acid is included.

6. Polishing agent according to any one of claims 1 to 5, **characterised in that** constituent (c) is included in a share of 0.005 to 5 mass%.

7. Polishing agent according to any one of claims 1 to 6, **characterised in that** as further constituent (e) one or several basic sats and/or hydroxides of alkali metal ions and/or ammonium ions are included in a share of 0.01 to 10 mass%.

8. Polishing agent according to any one of claims 1 to 7 with a ph-value of 9 to 12, containing as constituents
(a) water in a share of 84 to 99.8 mass%,
(b) silicic acid in a share of 0.1 to 10 mass%, calculated as SiO₂,
(c) sodium or potassium salt of the iminodisuccinic acid and/or the ethylenediamine disuccinic acid in a share of 0.01 to 1 mass%, and
(d) sodium and/or potassium carbonate In a share of 0.05 to 5 mass%,
(e) potassium or sodium gluconate to a share of 0.01-0.5 mass%.

9. Process for polishing a semiconductor wafer with a front and a back and an edge, **characterised in that** a polishing agent according to any one of claims 1 to 8 is used.

10. Process according to claim 9, **characterised in that** the semiconductor wafer is essentially made of silicon.

11. Process according to claim 9 or 10, **characterised in that** at least a part of the front of the semiconductor wafer is covered with artifically applied layers and/or structures.

12. Process according to claim 11, **characterised in that** in the layers and/or structures copper is included as electric conductor.

13. Process according to claim 9 or 10, **characterised in that** the front of the silicon wafer is not covered or covered with natural oxide and is polished under supply of a polishing agent according to any one of claims 1 to 9.

14. Process according to claim 9 or 10, **characterised in that** the front and the back of the silicon wafer are not covered or covered with natural oxide and are polished under supply of a polishing agent according to any one of claims 1 to 9.

15. Process according to claim 9 or 10, **characterised in that** the edge of the silicon wafer is polished under supply of a polishing agent according to any one of claims 1 to 9.

16. Process according to any one of claims 9 to 15, **characterised in that** at least a part of the used polishing agent is used again.

17. Use of a mixture made of
a) water,
b) abrasive substance and/or colloid.
c) methylglycine diacetic acid or a disuccinate of the formula 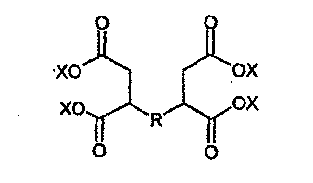 wherein
X and R have the meanings cited in claim 1 and
(d) alkali or alkaline-earth salts of gluconic acid as polishing agent, preferably as polishing agent for semiconductor wafers.

## Revendications

1. Agent de polissage comprenant en tant que composants de
a) l'eau,
b) un abrasif et/ou un colloïde,
c) de l'acide méthylglycine diacétique ou un disuccinate de formule : 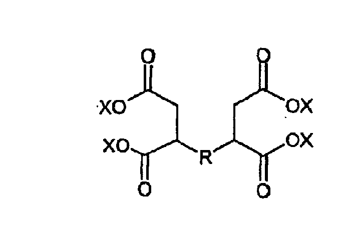 dans laquelle
R représente -(NH-CH₂-CH₂-)ₙNH-,
X représente de l'hydrogène et/ou un métal alcalin,
n un nombre entier de 0 à 2 et
d) un sel alcalin ou un sel alcalinoterreux de l'acide gluconique.

2. Agent de polissage selon la revendication 1, **caractérisé en ce que** l'acide silicique y est contenu en tant que composant (b) dans une proportion de 0,05 à 50 %m(i), calculé comme SiO₂.

3. Agent de polissage selon la revendication 1 ou 2, **caractérisé en ce que** le pH va de 8 à 13.

4. Agent de polissage selon l'une des revendications 1 à 3, **caractérisé en ce que** les sels de sodium ou de potassium sont utilisés en tant que sels alcalins de l'acide gluconique.

5. Agent de polissage selon l'une des revendications 1 à 4, **caractérisé en ce que** l'acide iminodisuccinique (n = 0) et/ou l'acide éthylène-diamine-disuccinique (n = 1) et/ou le disuccinate de diéthylènetriamine et/ou un ou plusieurs sels de ces composés ou l'acide méthylglycine diacétique y est contenu en tant que composant (c).

6. Agent de polissage selon l'une des revendications 1 à 5, **caractérisé en ce que** le composant (c) y est contenu dans une proportion de 0,005 à 5 %m(i).

7. Agent de polissage selon l'une des revendications 1 à 6, **caractérisé en ce que** un ou plusieurs sels basiques et/ou hydroxydes des ions de métaux alcalins et/ou des ions d'ammonium y sont contenus en tant qu'autres composants (e) dans une proportion de 0,01 à 10 %m(i).

8. Agent de polissage selon l'une des revendications 1 à 7 dont le pH va de 9 à 12, comprenant en tant que composants de
(a) l'eau dans une proportion de 84 à 99,8 %m(i),
(b) l'acide silicique dans une proportion de 0,1 à 10 %m(i), calculé comme SiO₂,
(c) du sel de sodium ou de potassium de l'acide iminodisuccinique et/ou de l'acide éthylène-diamine-disuccinique dans une proportion allant de 0,01 à 1 %m(i), et
(d) du carbonate de sodium et/ou de potassium dans une proportion allant de 0,05 à 5 %m(i),
(e) du gluconate de potassium ou de sodium dans une proportion de 0,01 à 0,5 %m(i).

9. Procédé pour le polissage d'une pastille de semi-conducteur munie d'une face avant, d'une face arrière et d'un bord, **caractérisé en ce que** l'agent de polissage est utilisé selon l'une des revendications 1 à 8.

10. Procédé selon la revendication 9, **caractérisé en ce que** la pastille de semi-conducteur se compose pour l'essentiel de silicium.

11. Procédé selon la revendication 9 ou 10, **caractérisé en ce qu'**au moins une partie de la face avant de la pastille de semi-conducteur est recouverte de couches et/ou de textures posées de manière artificielle.

12. Procédé selon la revendication 11, **caractérisé en ce que** du cuivre est contenu dans les couches et/ou textures en tant que conducteur électrique.

13. Procédé selon la revendication 9 ou 10, **caractérisé en ce que** la face avant de la pastille de silicium est découverte ou recouverte d'oxyde naturel et est polie en apportant un agent de polissage selon l'une des revendications 1 à 9.

14. Procédé selon la revendication 9 ou 10, **caractérisé en ce que** les faces avant et arrière de la pastille de silicium sont découvertes ou recouvertes d'un oxyde naturel et sont polies en apportant un agent de polissage selon l'une des revendications 1 à 9.

15. Procédé selon la revendication 9 ou 10, **caractérisé en ce que** le bord de la pastille de silicium est poli en apportant un agent de polissage selon l'une des revendications 1 à 9.

16. Procédé selon l'une des revendications 9 à 15, **caractérisé en ce qu'**au moins une partie de l'agent de polissage employé est réutilisée.

17. Utilisation d'un mélange composé
a) d'eau,
b) d'un abrasif et/ou d'un colloïde,
c) d'un acide méthylglycine diacétique ou d'un disuccinate de formule : 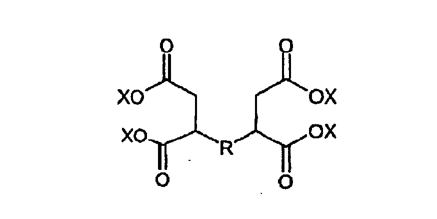 dans laquelle
X et R ont les significations nommées dans la revendication 1 et
(d) les sels alcalins ou alcalinoterreux de l'acide gluconique sont utilisés en tant qu'agent de polissage, de préférence en tant qu'agent de polissage pour les pastilles de semi-conducteur.
